# EUROPÄISCHE PATENTSCHRIFT

(11) **EP 1 093 153 B1**
(45) Veröffentlichungstag und Bekanntmachung des Hinweises auf die Patenterteilung: **05.07.2006**
(21) Anmeldenummer: 00120610.1
(22) Anmeldetag: 21.09.2000
(51) Int. Cl.: H01L 21/00

(54) **Einrichtung und Verfahren zum Einbringen verschiedener transparenter Substrate in ein hochgenaues Messgerät**
Device and method for introducing different transparent substrates in a high-precision measuring apparatus
Dispositif et méthode pour introduire différents substrats transparents dans un appareil de mesure à haute précision

(30) Priorität: 11.10.1999 DE 19949005
(43) Veröffentlichungstag der Anmeldung: 18.04.2001
(73) Patentinhaber: Leica Microsystems Semiconductor GmbH, 35578 Wetzlar (DE)
(72) Erfinder: Bläsing-Bangert, Carola, 35625 Hüttenberg (DE); Kaczynski, Ulrich, 61231 Bad Nauheim (DE)
(74) Vertreter: Reichert, Werner Franz

(56) Entgegenhaltungen:
- US-A- 4 542 712
- OTOTAKE T; MATSUBARA E; HOSOI K: "ADVANCED MASK METROLOGY SYSTEM FOR UP TO 4GBIT DRAM" PROCEEDINGS OF THE SPIE, Bd. 3096, 1997, Seiten 433-444, XP000943643 BELLINGHAM, VA, US
- PATENT ABSTRACTS OF JAPAN vol. 1996, no. 10, 31. Oktober 1996 (1996-10-31) -& JP 08 145900 A (HITACHI LTD), 7. Juni 1996 (1996-06-07)
- PATENT ABSTRACTS OF JAPAN vol. 1998, no. 05, 30. April 1998 (1998-04-30) -& JP 10 022226 A (SUPER SILICON KENKYUSHO:KK), 23. Januar 1998 (1998-01-23)
- PATENT ABSTRACTS OF JAPAN vol. 1998, no. 09, 31. Juli 1998 (1998-07-31) -& JP 10 107117 A (KOKUSAI ELECTRIC CO LTD), 24. April 1998 (1998-04-24)

## Beschreibung

Die Erfindung betrifft eine Einrichtung zum Einbringen verschiedener Substrate in ein hochgenaues Messgerät. Insbesondere betrifft die Erfindung eine Einrichtung, die ein Magazin umfasst, in dem mehrere Fächer ausgebildet sind, in denen Substrathalter für unterschiedliche Substrate ablegbar sind.

Ferner betrifft die Erfindung ein Verfahren zum Einbringen verschiedener Substrate in ein hochgenaues Messgerät.

Die Patentschrift US-A-5,026,239 beschreibt eine Maskenkassette und einen Lademechanismus für die Maskenkassette. Eine Vielzahl von Masken werden in einer Maskenkassette aufbewahrt, die gegenüber der Umgebungsluft verschließbar ist. Die Maskenkassette befindet sich anfänglich in einer Maskenkammer, die durch eine kleine Öffnung mit einer Hauptkammer in Verbindung steht. Beide Kammern sind hermetisch nach außen hin abgeschlossen. In der Maskenkammer wird die Maskenkassette geöffnet und entsprechend so in Position gebracht, dass eine Greif- und Transportvorrichtung auf die einzelnen Masken zugreifen kann. Die Masken werden von der Greif- und Transportvorrichtung über die kleine Öffnung in die Hauptkammer verbracht und dort entsprechend belichtet. Im vorliegenden Ausführungsbeispiel handelt es sich um eine Belichtung mit Röntgenstrahlen, so dass aus Gründen der Reinheit beide Kammern evakuiert werden müssen.

Ein System zur Maskenvermessung ist im SPIE, Vol. 3096; 0277-786X/97 (Author : Taro Ototake; Titel: Advanced Mask Metrology System for up to 4 Gbit DRAM) (Seiten 433 bis 444) veröffentlicht. Das System umfasst eine automatische Ladevorrichtung für verschiedene Substrattypen. Die verschiedenen Substrate befinden sich in Schubfächern in einem Magazin. Ebenfalls ist ein Magazin vorgesehen, das über einem Drehtisch drei Fächer besitzt, in denen jeweils unterschiedliche Substrathalter abgelegt sind. Der Nachteil dieses Systems ist, dass durch die bewegbaren Schubfächer des Magazins Verunreinigungen auftreten können, die sich auf den Substraten niederschlagen und somit die Reproduzierbarkeit der Messung nachteilig beeinflussen.

Der Erfindung liegt daher die Aufgabe zugrunde, eine Einrichtung zu schaffen, mit der die Reproduzierbarkeit der Messergebnisse deutlich verbessert wird. Es sollen durch die vorliegende Erfindung die Mängel des Standes der Technik, wie z.B. Ablagerung von Partikeln der Substrate beim Bewegen der Fächer des Magazins erleichtert werden, sowie eine Erleichterung des Substrathandlings für den Operator und eine Überwachung des thermischen Gleichgewichts erzielt werden.

Diese Aufgabe wird bei einer Einrichtung der eingangs genannten Art erfindungsgemäß dadurch gelöst, dass eine Ladestation in der die Substrathalter für unterschiedliche Substrate mit zum Substrathalter passenden Substrat beladbar sind, eine automatische Transfereinrichtung, die vom Magazin Substrathalter entnimmt und in die Ladestation einlegt oder aus der Ladestation die Substrathalter zusammen mit dem eingelegten Substrat entnimmt und entsprechende Sensoren, die den Typ des geladenen Substrats ermitteln und mit dem Substrathalter vergleichen, vorgesehen sind.

Der Erfindung liegt weiterhin die Aufgabe zugrunde, ein Verfahren zu schaffen, mit dem zu vermessende Substrate in ein hochgenaues Messgerät geladen werden können und dabei eine Höchstmaß an Reproduzierbarkeit der Messergebnisse gewährleistet ist.

Diese Aufgabe wird bei einem Verfahren der eingangs genannten Art dadurch gelöst, dass das Verfahren folgende Schritte umfasst:
- Laden eines bestimmten Substrathalters in die Ladestation,
- Einlegen eines zum Substrathalter passenden Substrattyps in die Ladestation,
- Überprüfen der Übereinstimmung von geladenem Substrathalter und eingelegtem Substrattyp,
- Aufnehmen des Substrats in dem Substrathalter mittels der Transporteinrichtung und
- Überführen des aufgenommenen Substrathalters zusammen mit dem geladenen Substrat in das hochgenaue Messgerät.

Vorteilhafte Weiterbildungen ergeben sich aus den Merkmalen der Unteransprüche.

Mit der erfindungsgemäßen Ausgestaltung des an sich bekannten Messgerätes wird es möglich, die Punkte, die in der Vergangenheit zu Problemen geführt haben, zu beseitigen. (Dies betrag z.B. Partikelablagerungen auf den Substraten beim Einschieben der Schubladen des Magazin, da die Schubladen ohne "Stopper" einfach herausgezogen werden konnten. Die Ablagefächer für die Substrate waren ziemlich eng; bei größeren Substraten war es sehr schwer, die Substrate per Hand einzulegen; oder es gab keine Überwachung, ob sich bereits in einem Fach ein Substrat befand.)

Um einen sicheren Ablauf der Beladung zu gewährleisten, erfolgt die Beladung der Substrathalter nur über die Ladestation. Um hierbei dem Bedienpersonal das Arbeiten zu erleichtern, ist die Ladestation in einer ergonomischen Höhe von ca. 90 - 95 cm angebracht. Der Bediener (Operator) legt das Substrat auf den rahmenförmigen Substrathalter innerhalb der Ladestation. Die Auflageflächen des Substrathalters für das Substrat können sehr klein dimensioniert werden, da das Substrat vollautomatisch auf den Substrathalter geladen wird. Ein Magazin wird ausschließlich mit Hilfe eines Roboterarms mit dem Substrathalter samt den aufgelegten Substraten beladen. Es gibt keine Schubladen mehr, so dass keine Partikel mehr generiert werden, welche die Substrate in den Fächern des Magazins verunreinigen könnten. Ferner besteht die Möglichkeit, eine vollautomatische Beladung aus einem Carrier zu integrieren.

In der Zeichnung ist der Erfindungsgegenstand des Messgerätes schematisch dargestellt und wird anhand der Figuren nachfolgend beschrieben. Dabei zeigen:
- Fig. 1:: eine schematische Seitenansicht des Messgerätes,
- Fig. 2:: eine schematische Darstellung des Aufbaus der Einrichtung,
- Fig. 3a bis 3d:: eine graphische Darstellung der Aufnahme eines Substrats in der Ladestation der Einrichtung, und
- Fig. 4: ein Ablaufdiagramm zur Darstellung des erfindungsgemäßen Verfahrens.

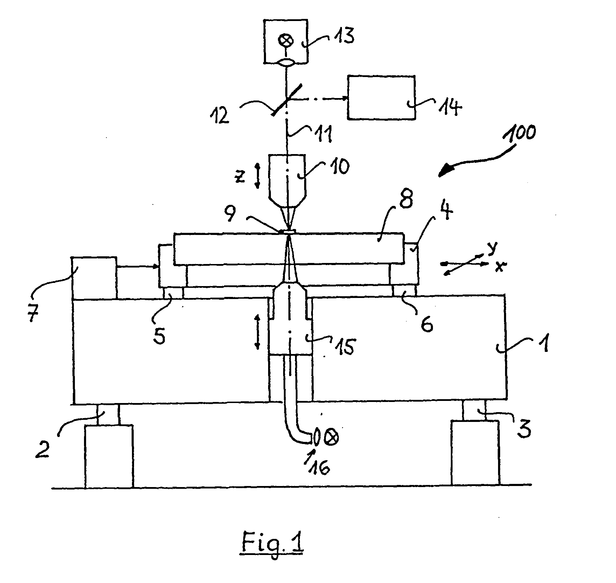

Das in Fig. 1 dargestellte hochgenaue Messgerät 100 besteht aus einem Granitblock 1, der auf Füßen 2, 3 schwingungsgedämpft gelagert ist. Auf dem Granitblock 1 ist ein als Rahmen ausgebildeter XY-Schlitten 4 auf Luftlagern 5, 6 in den zwei durch Pfeile angedeuteten Richtungen gleitend verschiebbar. Der Rahmen des XY-Schlitten 4 besteht vorteilhafterweise aus einer Keramik mit geringem thermischen Ausdehnungskoeffizienten. Die Antriebe dafür sind nicht dargestellt. Die Position des XY-Schlittens 4 wird mit einem Meßsystem 7, vorzugsweise Lasersystem oder Glasmaßstab, in X- und Y-Richtung gemessen. In den Rahmen des XY-Schlitten 4 ist ein Substrat 8 eingelegt. Das Substrat 8 besteht z.B. aus Glas (vorzugsweise Quarzglas). Auf der Substratoberfläche sind Strukturen 9 aufgebracht. Da der XY-Schlitten 4 als Rahmen ausgebildet ist, kann das Substrat 8 auch von unten her durchleuchtet werden. Bei nicht lichtdurchlässigen Substraten findet dann eine Beleuchtung mit Auflicht statt. Die weitere Beschreibung beschränkt sich auf die Beleuchtung von lichtdurchlässigen Substraten. Dies soll in keiner Weise als eine Beschränkung der Anmeldung aufgefasst werden.

Oberhalb des Substrats 8 befindet sich ein Abbildungssystem 10 hoher optischer Güte, das zur Fokussierung längs seiner optischen Achse 11 in Z-Richtung verstellbar ist. Über einen Teilerspiegel 12 wird zum einen das Licht einer Lichtquelle 13 in den optischen Strahlengang eingeleitet und zum anderen werden die Abbildungsstrahlen auf eine Detektor-Einrichtung 14 gelenkt. Die Detektor-Einrichtung 14 ist z.B. eine CCD-Kamera mit hochauflösendem Pixelarray. Die Lichtquelle 13 emittiert im nahen UV-Spektralbereich.

In den Granitblock 1 ist eine weitere Beleuchtungseinrichtung eingesetzt, die aus einem höhenverstellbaren Kondensor 15 und einer Lichtquelle 16 besteht. Als Lichtquelle 16 kann auch die Austrittsfläche eines Lichtleiters vorgesehen sein. Die optische Achse des Kondensors 15 fluchtet mit der optischen Achse 11 des Abbildungssystems 10. Die Höhenverstellung des Kondensors 15 mit Lichtquelle 16 dient der Anpassung der auf die Struktur 9 zu richtenden Beleuchtungsstrahlen an unterschiedliche optische Dicken der Substrate 8. Der Kondensorkopf kann insbesondere in den offenen Teil des Rahmens des XY-Schlittens 4 hineinreichen. Zum Schutz vor Beschädigungen bei Tischverschiebungen über die gesamte Substratfläche kann er unter die Oberfläche des Granitblocks 1 gezogen werden. Die Lichtquellen 13 und 16 sind voneinander unabhängig einschaltbar.

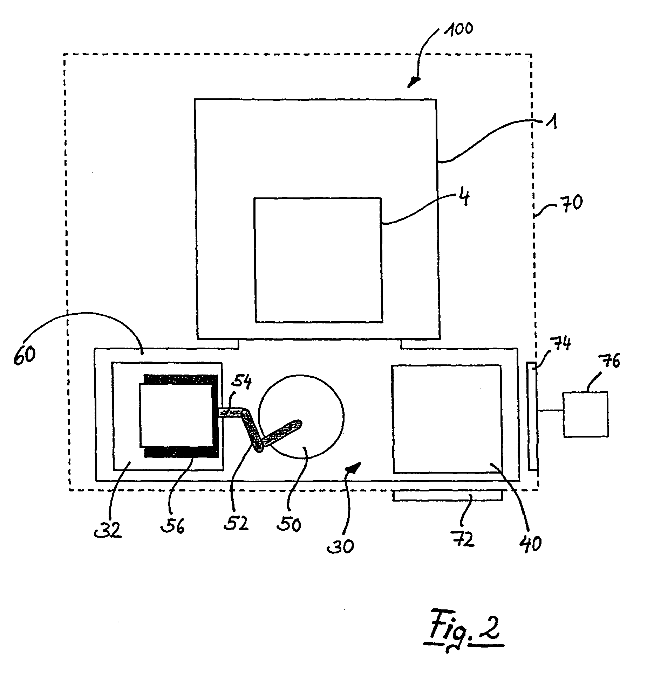

Eine schematische Darstellung des hochgenauen Messgeräts 100 mit mehreren Zusatzgeräten ist in Fig. 2 dargestellt. Wie bereits bei der Beschreibung der Fig. 1 erwähnt, befindet sich auf dem Granitblock 1 der XY-Schlitten 4. Um die schematische Darstellung der Einrichtung nicht unnötig zu komplizieren, sind beim hochgenauen Messgerät 100 einige Bauteile nicht dargestellt. Auf den XY-Schlitten 4 können die zur Vermessung bestimmten Substrate 8 geladen werden. Zum Laden der Substrate 8 in das hochgenaue Messgerät 100 ist ein Magazin 32 vorgesehen, in dem mehrere Fächer (nicht dargestellt) ausgebildet sind. In den Fächern sind Substrathalter 34 für die unterschiedlichen Substrattypen abgelegt. Des weiteren ist es möglich, dass in den Fächern ebenfalls Substrathalter 34 mit einem eingelegtem Substrat 8 eingelagert werden. Ein erster Grund, warum die Substrathalter 34 mit einem eingelegten Substrat 8 in dem Magazin 32 abgelegt werden, ist, dass für die hochgenaue Messung ein Temperaturgleichgewicht erreicht werden muss. Ein zweiter Grund ist, dass alle zu vermessenden Substrate 8 in den entsprechenden Substrathaltern 34 für eine spätere Abarbeitung in den Fächern des Magazins 32 zwischengelagert sind.

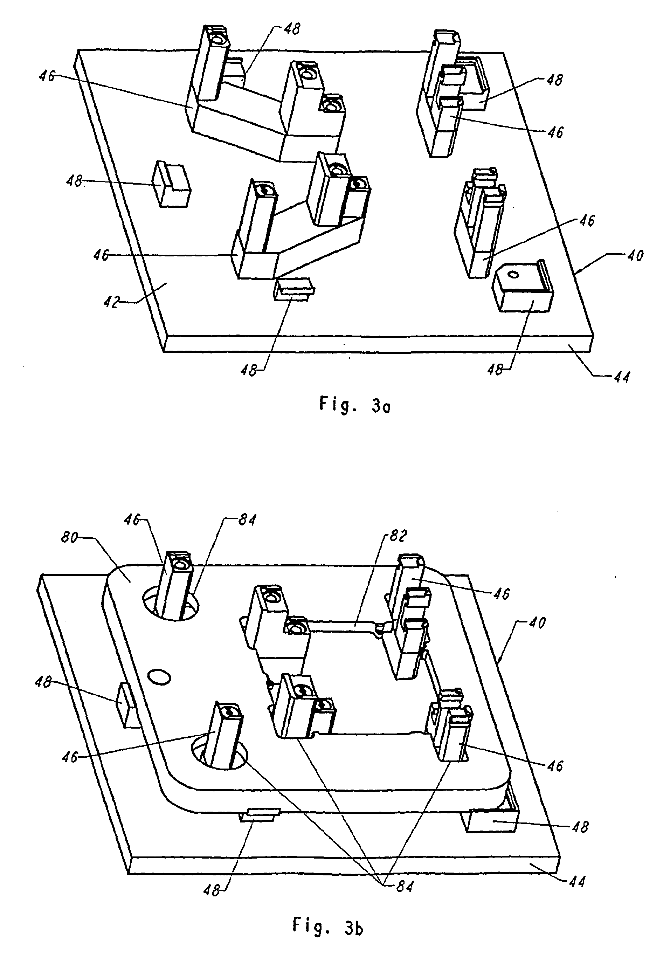

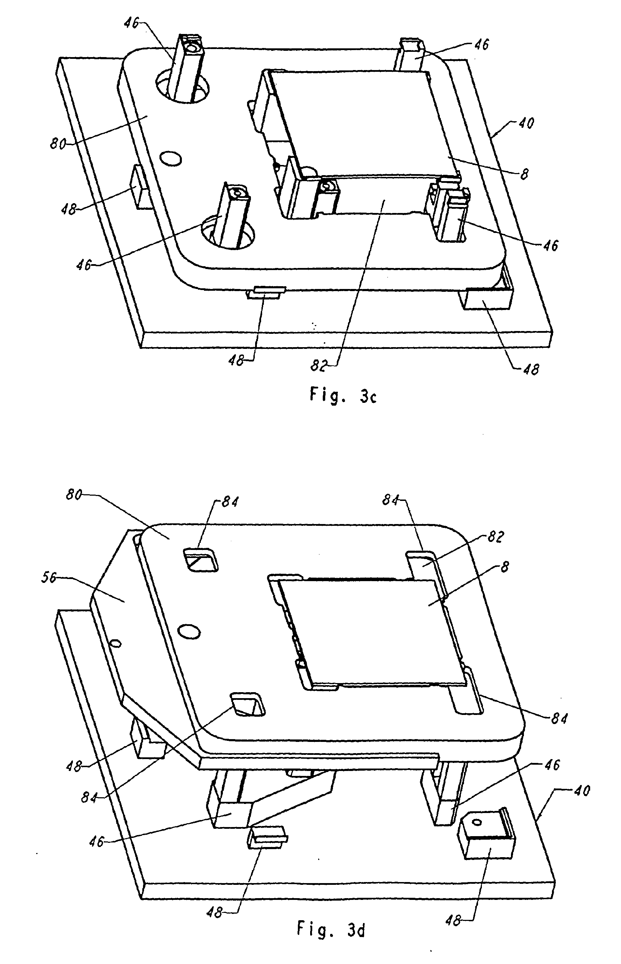

Eine Ladestation 40 (genauere Beschreibung siehe Fig. 3) ist ebenfalls in räumlicher Nähe des Magazins 32 vorgesehen. Zwischen dem Magazin 32 und der Ladestation 40 befindet sich eine automatische Transporteinrichtung 50, die derart ausgebildet ist, dass sie die Substrathalter 34 in die Ladestation einführen kann, die Substrathalter 34 zusammen mit dem eingelegten Substrat 8 in das Magazin 32 oder das hochgenaue Messgerät 100 überführen kann oder den Substrathalter 34 aus dem hochgenauen Messgerät 100 entnehmen kann. Die automatische Transporteinrichtung 50 besitzt einen Roboterarm 52, an dessen vorderem Ende 54 eine Gabel 56 ausgebildet ist, mit der die Substrathalter 34 aufgenommen und transportiert werden können.

In dem hier dargestelltem Ausführungsbeispiel sind das Magazin 32, die automatische Transporteinrichtung 50 und die Ladestation 40 auf einer Plattform 60 montiert. Mittels der Plattform 60 wird immer eine definierte Lage der einzelnen Elemente (Magazin 32, automatische Transporteinrichtung 50, Ladestation 40 und hochgenaues Messgerät 100) zueinander garantiert. Ein weiterer Vorteil durch die Montage auf der Plattform 60 ist, dass das Magazin 32, die automatische Transporteinrichtung 50 und die Ladestation 40 vom hochgenauen Messgerät 100 sehr schnell abkoppelbar sind, wodurch ein besserer Zugang für das Servicepersonal zum hochgenauen Messgerät 100 erzielbar ist. Hinzu kommt, dass mittels der am hochgenauen Messgerät 100 angedockten Plattform 60 immer eine korrekte Ausrichtung bzw. Justage der einzelnen Elemente ermöglicht ist.

Falls es aufgrund der Messbedingungen erforderlich ist, werden das hochgenaue Messgerät 100, das Magazin 32, die automatische Transporteinrichtung 50 und die Ladestation 40 in einem klimatisierten Raum 70 untergebracht. Der klimatisierte Raum ist durch mehrere Wandungen 71 definiert, von denen in Fig. 2 lediglich die Seitenwandungen dargestellt sind. Der klimatisierte Raum 70 ist im Bereich der Ladestation 40 mit einer verschließbaren Ladeöffnung 72 versehen, durch die es einer Bedienperson möglich ist, Substrate von außen in die Ladestation 40 einzugeben. In einer weiteren Ausgestaltung ist zusätzlich im Bereich der Ladestation 40, die den Wandungen 71 des klimatisierte Raumes 70 gegenüberliegt, eine weitere Übergabeschnittstelle 74 vorgesehen. An dieser Übergabeschnittstelle 74 kann z.B. ein automatisches Ladesystem 76 angesetzt werden. Das automatische Ladesystem 76 führt dann von einem Transportbehälter die verschiedenen Substrate 8 nacheinander in die Ladestation 40 ein. Das automatische Ladesystem 76 kann z.B. mit einem automatisch geführtem Fahrzeug (Automated Guided Vehicle) oder Transportwagen realisiert werden, und zwar derart, dass das automatisch geführte Fahrzeug oder der Transportwagen mit der Übergabeschnittstelle 74 in Verbindung gebracht wird.

Im folgenden sind Ausführungsbeispiele für das Magazin 32, die automatische Transfereinrichtung 50 und der Ladestation 40 offenbart.

Das Magazin 32 ist für acht bis zehn Fächer für acht bis zehn Substrathalter 80 oder auch Waferchucks (nicht dargestellt) ausgelegt; die genaue Anzahl richtet sich nach der Verfügbarkeit und dem Preis der automatischen Transporteinrichtung 50 und, falls notwendig, nach der Innenraumhöhe des klimatisierten Raums 70. Die Außenmaße der Substrathalter 80 sind gleich für alle Substrate oder Wafer. Zur Identifizierung des Typs des Substrathalters 80 ist an der Außenseite eine Kodierung angebracht. Zur Erleichterung der Prozesskontrolle für das gesamte Messsystem sind mehrere Sensoren (nicht dargestellt) vorgesehen. Ein Sensor dient zum Lesen der Kodierung (nicht dargestellt) auf dem Substrathalter 80, um zu erkennen, welcher Substrathalter-Typ in welchem Fach des Magazins 32 abgelegt ist. Ferner sind Temperatursensoren (nicht dargestellt) in jedem Fach des Magazins 32 vorgesehen. Die Temperatursensoren müssen nicht absolut geeicht sein. Sie dienen lediglich der Kontrolle, ob sich die Substrattemperatur stabilisiert hat, um eine reproduzierbare Messung durchführen zu können. Ferner können noch Substrat-Exist-Sensoren (nicht dargestellt) in jedem Fach vorhanden sein, die anzeigen, ob sich im Substrathalter 8 ein Substrat befindet.

Die automatische Transporteinrichtung 50 handhabt Substrate 8 mit Substrathaltern 34 bzw. Wafer mit Waferchucks. Hierbei erreicht das zu transportierende Gewicht bis zu 4 kg. Die automatische Transporteinrichtung besitzt einen Roboterarm 52, der einen maximalen Hebel 500 mm bei einem Rotationswinkel von 190° aufweist. Es ist nur noch eine einzige Gabel 56 für die Verwendung am Roboterarm vorgesehen, da die Außenmaße aller Substrathalter 80 für alle Substrate 8 und Wafer die gleichen sind. Das Wechseln der Gabel 56 von einem Substrattyp zu einem anderen entfällt. Auf einer Seite der Gabel 56 kann z.B. ein Sensor angebracht sein, der die Substrathalter 80 identifiziert.

Die Ladestation 40 ist räumlich derart konzipiert, dass die Bedienperson das manuelle Be- und Entladen der Substrathalter 80 mit den Substraten 8 leicht vornehmen kann.

Der Ablauf der Beladung eines Substrathalters 80 mit einem entsprechenden Substrat 8 ist in Fig. 3a bis 3d dargestellt.

Fig. 3a zeigt eine perspektivische Darstellung der Ladestation 40. Die Ladestation 40 besteht aus einer Bodenplatte 42, an der ein umlaufender Rand 44 ausgebildet ist. Auf der Bodenplatte 42 sind mehrere Tragmittel 46 angeordnet, die derart auf der Bodenplatte 42 verteilt sind, dass eine stabile Auflage für die Substrate 8 gewährleistet ist. Im vorliegenden Fall sind vier Tragmittel 46 vorgesehen. Zusätzlich zu dem Tragmittel 46 sind auf der Bodenplatte Aufnahmeelemente 48 angebracht, die einen Substrathalter 80 (siehe Fig. 3b) derart tragen, dass er die Tragmittel 46 umschließt und in seiner Lage ausgerichtet und orientiert ist. Die Ausrichtung des Substrathalters 80 ist durch die Aufnahmeelemente 48 gegeben.

Fig. 3b zeigt den in die Ladestation 40 eingelegten Substrathalter 80. Der Substrathalter 80 hat eine Aussparung 82 definiert, die entsprechend der Länge und der Breite der verwendeten Substrate 8 bestimmt ist. Zusätzlich sind im Substrathalter 80 Führungsaussparungen 84 vorgesehen, die derart im Substrathalter 80 angeordnet sind, dass sie der räumlichen Anordnung der Tragmittel 46 der Ladestation 40 entsprechen. Beim Einsetzen des Substrathalters 80 in die Ladestation 40 greifen Teile der Tragmittel 46 in die Führungsaussparungen 84 des Substrathalters 80 ein und gewährleisten dadurch eine grobe Führung des Substrathalters. Die Führungsaussparungen 84 sind derart bemessen, dass zwischen ihnen und den Tragmitteln 46 ein Spiel besteht. Ist der Substrathalter 80 in die Ladestation 40 eingesetzt, dann ruht er auf den Aufnahmeelementen 48, durch die er exakt ausgerichtet und positioniert wird.

Fig. 3c zeigt einen in der Ladestation 40 befindlichen Substrathalter 80 und ein auf den Tragmitteln 46 ruhendes Substrat 8. Das Substrat 8 ist entsprechend dem Substrathalter 80 ausgewählt, so dass es in die Aussparung 82 des Substrathalters 80 passt. Geeignete Mittel (Sensoren, Datenverarbeitungsanlage) sind vorgesehen um die Übereinstimmung zwischen Substrat 8 und Substrathalter 80 zu überprüfen. Das Substrat 8 wird von einer Bedienperson per Hand oder mit einem geeigneten Werkzeug in die Ladestation 40 eingelegt. Ebenso kann das Einlegen der Substrate 8 auch automatisiert sein.

Fig. 3d stellt das Abheben des Substrathalters 80 zusammen mit einem eingelegtem Substrat 8 dar. Bei der Übereinstimmung von Substrathalter 80 und Substrat 8, kann der Substrathalter 80 von der Ladestation 40 abgehoben werden. Hierzu fährt die Gabel 56 des Roboterarms 52 (nicht dargestellt) unter den Substrathalter 80, der auf den Aufnahmeelementen 48 ruht. Durch die Hubbewegung des Roboterarms 52 hebt die Gabel 56 den Substrathalter 80 an, der dabei das in der Ladestation 40 befindliche Substrat 8 mitnimmt. Das Substrat 8 kommt in der Aussparung 82 des Substrathalters 80 zu liegen. Ebenso werden durch die Hubbewegung des Roboterarms 56 die Tragmittel 46 der Ladestation 40 aus den Führungsaussparungen 84 des Substrathalters 80 herausbewegt. Die Einheit an dem Substrathalter 80 und dem Substrat 8 kann nun durch den Roboterarm 52 in das hochgenaue Messgerät 100 oder in das Magazin 32 (Fig.2) überführt werden.

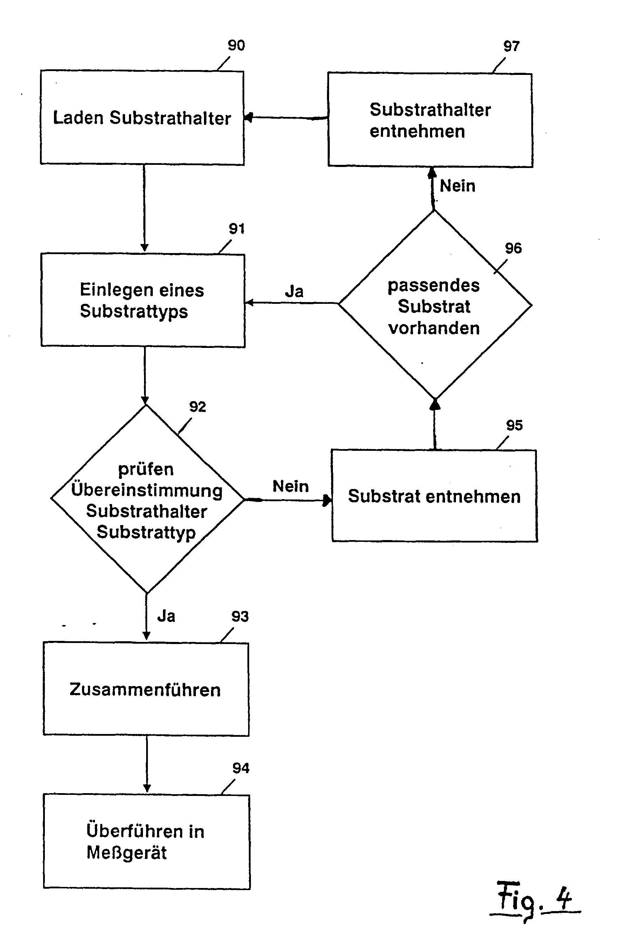

Fig. 4 offenbart in einem Ablaufdiagramm das Verfahren zum Einbringen verschiedener Substrate in ein hochgenaues Messgerät. In einem ersten Schritt 90 erfolgt das Laden eines bestimmten Substrathalters 80 in die Ladestation 40. Wie bereits oben erwähnt wird hierzu eine automatische Transporteinrichtung 50 verwendet. In einem zweiten Schritt 91 wird ein Substrat 8 eines bestimmten Substrattyps in die Ladestation 40 eingelegt. Das Einlegen eines Substrats 8 in die Ladestation kann von einer Bedienperson per Hand oder automatisiert durchgeführt werden. In einem dritten Schritt 92 erfolgt eine Überprüfung, ob der Substrathalter 80 zu dem eingelegtem Substrat 8 passt. Geeignete Sensoren sind vorgesehen, die mit einer Datenverarbeitungsanlage in Verbindung stehen. Wird eine Übereinstimmung festgestellt, so wird mit einem vierten Schritt 93 fortgefahren. Hier wird der Substrathalter 80 mittels der Gabel 56 des Roboterarms 52 angehoben. Das Substrat 8 kommt hierbei in der Aussparung 82 des Substrathalters 80 zu liegen. In einem fünften Schritt 94 wird dann der Substrathalter 80 zusammen mit dem Substrat 8 in das Messgerät 100 überführt. Es ist aber ebenso denkbar, dass der Substrathalter 80 zusammen mit dem Substrat 8 zuerst zur Temperaturstabilisierung in einem Fach des Magazins 32 abgelegt wird. Nachdem ein Temperaturgleichgewicht erreicht worden ist, wird der Substrathalter 80 zusammen mit dem Substrat 8 in das Messgerät 100 eingelegt. Sollte sich im dritten Schritt 92 herausstellen, dass der Substrate nicht mit dem Substrathalter 80 übereinstimmt, folgt ein sechster Schritt 95. Das Substrat 8 wird aus der Ladestation 40 entnommen (per Hand oder automatisch). Anschließend folgt ein siebter Schritt 96, mit dem geprüft wird, ob für den in der Ladestation 40 befindlichen Substrathalter 80 ein passendes Substrat 8 vorhanden ist. Ist dies der Fall, so läuft das Verfahren erneut ab dem zweiten Schritt 91 ab. Wurde festgestellt, das kein passendes Substrat 8 vorhanden ist, wird ein achter Schritt 97 ausgeführt. Der Substrathalter 80 wird aus der Ladestation 40 entnommen und ein Substrathalter 80 eingesetzt, der zu den vorhandenen Substraten 8 passt. Das Verfahren läuft dann erneut ab dem ersten Schritt 90 ab.

Die vorliegende Erfindung ist in Bezug auf Ausführungsbeispiele beschrieben worden. Es ist jedoch für jeden auf diesem Fachgebiet tätigen Fachmann offensichtlich, dass Änderungen und Abwandlungen vorgenommen werden können, ohne dabei den Schutzbereich der nachstehenden Ansprüchen zu verlassen.

**Teileliste**

| | | | |
|---|---|---|---|
| 1 | Granitblock | 50 | automatische Transfereinrichtung |
| 2 | Fuß | | |
| 3 | Fuß | 52 | Roboterarm |
| 4 | XY-Schlitten | 54 | vorderes Ende |
| 5 | Luftlager | 56 | Gabel |
| 6 | Luftlager | 60 | Plattform |
| 7 | Messsystem | 70 | klimatisierter Raum |
| 8 | Substrat | 71 | Wandungen |
| 9 | Strukturen | 72 | Ladeöffnung |
| 10 | Abbildungssystem | 74 | Übergabeschnittstelle |
| 11 | optischen Achse | 76 | automatisches Ladesystem |
| 12 | Teilerspiegel | | |
| 13 | Lichtquelle | 80 | Substrathalter |
| 14 | Detektor-Einrichtung. | 82 | Aussparung |
| 15 | höhenverstellbarer Kondensor | 84 | Führungsaussparungen |
| 16 | Lichtquelle | 90 | erster Schritt |
| 30 | Einrichtung | 91 | zweiter Schritt |
| 32 | Magazin | 92 | dritter Schritt |
| 34 | Substrathalter | 93 | vierter Schritt |
| 40 | Ladestation | 94 | fünfter Schritt |
| 42 | Bodenplatte | 95 | sechster Schritt |
| 44 | umlaufender Rand | 96 | siebter Schritt |
| 46 | Tragmittel | 97 | achter Schritt |
| 48 | Aufnahmeelemente | 100 | hochgenaues Messgerät |

## Patentansprüche

1. Einrichtung zum Einbringen verschiedener Substrate (8) in ein hochgenaues Messgerät (100), welche ein Magazin (32) umfasst, in dem mehrere Fächer ausgebildet sind, in denen Substrathalter (80) für unterschiedliche Substrate (8) ablegbar sind, **dadurch**
**gekennzeichnet, dass**
eine Ladestation (40), in der die Substrathalter (80) für unterschiedliche Substrate (8) mit zum Substrathalter (80) passenden Substrat (8) beladbar sind, eine automatische Transfereinrichtung (50), die vom Magazin (32) Substrathalter (80) entnimmt und in die Ladestation (40) einlegt oder aus der Ladestation (40) die Substrathalter (80) zusammen mit dem eingelegten Substrat (8) entnimmt, und entsprechende Sensoren, die den Typ des geladenen Substrats (8) ermitteln und mit dem Substrathalter (80) vergleichen, vorgesehen sind.

2. Einrichtung nach Anspruch 1, **dadurch gekennzeichnet, dass** das Substrat (8) zusammen mit dem Substrathalter (80) von der Ladestation (50) in das Messgerät (100) überführbar ist.

3. Einrichtung nach Anspruch 1, **dadurch gekennzeichnet, dass** das Magazin (32), die automatische Transporteinrichtung (50) und die Ladestation (40) auf einer Plattform (60) montiert und justiert sind und dass die Plattform (60) an das Messgerät (100) andockbar ist.

4. Einrichtung nach Anspruch 3, **dadurch gekennzeichnet, dass** die Ladestation (40) derart räumlich angeordnet ist, dass die Substrate von einer automatischen Transfereinrichtung (50) in die Ladestation (40) einlegbar oder daraus entnehmbar sind.

5. Einrichtung nach Anspruch 1, **dadurch gekennzeiehnet,** dass in jedem der Fächer des Magazins (32) ein Temperatursensor vorgesehen ist.

6. Verfahren zum Einbringen verschiedener Substrate in ein hochgenaues Messgerät (100) **gekennzeichnet durch** die folgenden Schritte:
- Laden eines bestimmten Substrathalters (80) in eine Ladestation (40),
- Einlegen eines zum Substrathalter (80) passenden Substrattyps in die Ladestation (40),
- Überprüfen der Übereinstimmung von geladenem Substrathalter (80) und eingelegtem Substrattyp,
- Aufnehmen des Substrats (8) in den Substrathalter (80) mittels der Transporteinrichtung (50), und
- Überführen des Substrathalters (80) zusammen mit dem aufgenommenen Substrat (8) in das hochgenaue Messgerät (100).

7. Verfahren nach Anspruch 6, **dadurch gekennzeichnet, dass** der Substrathalter (80) zusammen mit dem aufgenommenen Substrat (8) in ein Magazinfach überführt wird und dort für eine spätere Bearbeitung aufbewahrt wird.

8. Verfahren nach Anspruch 6, **dadurch gekennzeichnet, dass** in jedem Magazinfach das Temperaturgleichgewicht eines jeden Substrathalters (80) mit Substrat (8) durch einen Temperatursensor festgestellt wird, und dass Substrathalter (80) und Substrat (8) erst nach Erreichen des Temperaturgleichgewichts in das Messgerät (100) überführt werden.

9. Verfahren nach Anspruch 6, **dadurch gekennzeichnet, dass** das Überprüfen der Übereinstimmung von geladenem Substrathalter (80) und eingelegtem Substrat (8) **dadurch** erreicht wird, das in der Ladestation (40) entsprechende Sensoren vorgesehen sind, die den Typ des geladenen Substrats (8) ermitteln und mit dem Substrathalter (80) vergleichen.

10. Verfahren nach Anspruch 6, **dadurch gekennzeichnet, dass** eine Übergabeschnittstelle (74) vorgesehen ist, an welcher ein automatisches Ladesystem (76) angesetzt ist, das automatisch aus einem Transportbehälter die verschiedenen Substrate (8) nacheinander in die Ladestation (40) einlegt.

## Claims

1. Device for introducing different substrates (8) into a high-precision measuring apparatus (100), which device comprises a magazine (32), in which are formed a plurality of compartments in which substrate holders (80) for different substrates (8) can be deposited, **characterized in that** provision is made of a loading station (40), in which the substrate holders (80) for different substrates (8) can be loaded with a substrate (8) matching the substrate holder (80), an automatic transfer device (50), which removes substrate holders (80) from the magazine (32) and inserts them into the loading station (40) or removes the substrate holders (80) together with the inserted substrate (8) from the loading station (40), and corresponding sensors that determine the type of loaded substrate (8) and compare it with the substrate holder (80).

2. Device according to Claim 1, **characterized in that** the substrate (8) together with the substrate holder (80) can be transferred from the loading station (50) into the measuring apparatus (100).

3. Device according to Claim 1, **characterized in that** the magazine (32), the automatic transport device (50) and the loading station (40) are mounted and adjusted on a platform (60), and **in that** the platform (60) can be docked to the measuring apparatus (100).

4. Device according to Claim 3, **characterized in that** the loading station (40) is spatially arranged in such a way that the substrates can be inserted into the loading station (40), or can be removed therefrom, by means of an automatic transfer device (50).

5. Device according to Claim 1, **characterized in that** a temperature sensor is provided in each of the compartments of the magazine (32).

6. Method for introducing different substrates into a high-precision measuring apparatus (100), **characterized by** the following steps of:
- loading a specific substrate holder (80) into a loading station (40),
- inserting a substrate type that matches the substrate holder (80) into the loading station (40),
- checking the correspondence of loaded substrate holder (80) and inserted substrate type,
- receiving the substrate (8) into the substrate holder (80) by means of the transport device (50), and
- transferring the substrate holder (80) together with the received substrate (8) into the high-precision measuring apparatus (100).

7. Method according to Claim 6, **characterized in that** the substrate holder (80) together with the received substrate (8) is transferred into a magazine compartment and is kept there for later processing.

8. Method according to Claim 6, **characterized in that**, in each magazine compartment, the thermal equilibrium of each substrate holder (80) with substrate (8) is ascertairied by means of a temperature sensor, and **in that** substrate holder (80) and substrate (8) are transferred into the measuring apparatus (100) only after thermal equilibrium has been reached.

9. Method according to Claim 6, **characterized in that** checking the correspondence of loaded substrate holder (80) and inserted substrate (8) is achieved by virtue of the fact that corresponding sensors are provided in the loading station (40), which sensors determine the type of loaded substrate (8) and compare it with the substrate holder (80).

10. Method according to Claim 6, **characterized in that** a handover interface (74) is provided, to which an automatic loading system (76) is attached, which automatically inserts the different substrates (8) successively into the loading station (40) from a transport container.

## Revendications

1. Dispositif pour introduire différents substrats (8) dans un appareil de mesure de haute précision (100), qui comprend un magasin (32) dans lequel sont réalisés plusieurs compartiments, dans lesquels peuvent être posés des supports de substrats (80) pour différents substrats (8), **caractérisé en ce que**
l'on prévoit un poste de chargement (40), dans lequel les supports de substrats (80) pour différents substrats (8) peuvent être chargés avec un substrat (8) adapté au support de substrat (80), un dispositif de transfert automatique (50), qui prélève des supports de substrats (80) du magasin (32) et les dépose dans le poste de chargement (40) ou prélève du poste de chargement (40) les supports de substrats (80) conjointement avec le substrat introduit (8), et des capteurs correspondants, qui déterminent le type du substrat chargé (8) et le comparent avec le support de substrat (80).

2. Dispositif selon la revendication 1, **caractérisé en ce que** le substrat (8) peut être transféré conjointement avec le support de substrat (80) du poste de chargement (40) dans l'appareil de mesure (100).

3. Dispositif selon la revendication 1, **caractérisé en ce que** le magasin (32), le dispositif de transport automatique (50) et le poste de chargement (40) sont montés et ajustés sur une plate-forme (60) et **en ce que** la plate-forme (60) peut être accrochée à l'appareil de mesure (100).

4. Dispositif selon la revendication 3, **caractérisé en ce que** le poste de chargement (40) est disposé spatialement de telle sorte que les substrats puissent être posés par un dispositif de transfert automatique (50) dans le poste de chargement (40) ou puissent en être retirés.

5. Dispositif selon la revendication 1, **caractérisé en ce que** dans chacun des compartiments du magasin (32) est prévu un capteur de température.

6. Procédé pour introduire différents substrats dans un appareil de mesure (100) de haute précision, **caractérisé par** les étapes suivantes :
- chargement d'un support de substrat (80) déterminé dans un poste de chargement (40),
- dépose d'un type de substrat adapté au support de substrat (80) dans le poste de chargement (40),
- vérification de la correspondance entre le support de substrat chargé (80) et le type de substrat déposé,
- logement du substrat (8) dans le support de substrat (80) au moyen du dispositif de transport (50), et
- transfert du support de substrat (80) conjointement avec le substrat reçu (8) dans l'appareil de mesure de haute précision (100).

7. Procédé selon la revendication 6, **caractérisé en ce que** le support de substrat (80) est transféré conjointement avec le substrat reçu (8) dans un compartiment du magasin et y est conservé en vue d'un traitement ultérieur.

8. Procédé selon la revendication 6, **caractérisé en ce que** dans chaque compartiment de magasin, l'équilibre de température de chaque support de substrat (80) avec le substrat (8) est détecté par un capteur de température et **en ce que** le support de substrat (80) et le substrat (8) sont transférés dans l'appareil de mesure (100) seulement après l'obtention de l'équilibre de température.

9. Procédé selon la revendication 6, **caractérisé en ce que** la vérification de la correspondance entre le support de substrat chargé (80) et le substrat introduit (8) est réalisée en prévoyant dans le poste de chargement (40) des capteurs correspondants qui détectent le type de substrat chargé (8) et le comparent avec le support de substrat (80).

10. Procédé selon la revendication 6, **caractérisé en ce que** l'on prévoit une interface de transfert (74), sur laquelle est placé un système de chargement automatique (76) qui pose automatiquement les différents substrats (8) d'un récipient de transport les uns après les autres dans le poste de chargement (40).
